Europäisches Patentamt

European Patent Office

Office européen des brevets

(19)

(11) Publication number : **0 457 601 A2**

(12) **EUROPEAN PATENT APPLICATION**

(21) Application number : **91304442.6**

(22) Date of filing : **17.05.91**

(51) Int. Cl.⁵ : **H01L 21/84, H01L 21/336, H01L 21/205, H01L 29/784**

(30) Priority : **18.05.90 JP 128745/90**
**18.05.90 JP 128746/90**
**03.04.91 JP 70879/91**

(43) Date of publication of application :
**21.11.91 Bulletin 91/47**

(84) Designated Contracting States :
**DE FR GB NL**

(71) Applicant : **SEIKO EPSON CORPORATION**
**4-1, Nishishinjuku 2-chome**
**Shinjuku-ku Tokyo-to (JP)**

(72) Inventor : **Miyasaka, Mitsutoshi**
**c/o SEIKO EPSON CORPORATION,3-5 Owa**
**3-chome**
**Suwa-shi, Nagano-ken (JP)**

(74) Representative : **Miller, Joseph et al**
**J. MILLER & CO. Lincoln House 296-302 High**
**Holborn**
**London WC1V 7JH (GB)**

(54) Thin film semi-conductor device and method of producing same.

㉗    The present invention provides a method of producing a thin film semi-conductor device comprising forming an insulating layer (102) on a surface of a substrate (101), and depositing a silicon thin film as an active layer (105) above the insulating layer by low pressure chemical vapour deposition. The low pressure chemical vapour deposition is carried out using mono-silane ($SiH_4$) as a source gas and at a total reactor pressure of 15 mTorr or less or a silane partial pressure of 10 mTorr or less.

EP 0 457 601 A2

(a)

103
101
102

(b)

104    102

104
101

(c)

105

(d)

106

(e)

107

(f)

108    107    106
108
104
102    104    105    101

FIG. 1

The present invention relates to a method of producing a thin film semi-conductor device, which is suitable for application in active matrix liquid crystal displays, SRAMS and the like, and to a thin film semi-conductor device produced by such a method.

The screen size of liquid crystal displays and the resolution thereof are presently increasing with improvements in systems for driving liquid crystal displays from simple matrix systems to active matrix system. The active matrix system enables the formation of a liquid crystal display having several hundreds of thousands of pixels, and also allows a switching transistor to be formed for each of the pixels. As a result, a large volume of information can be displayed.

Transparent insulating substrates, such as melt quartz glass plates, glass plates and the like, all of which permit the formation of transparent displays, are used as substrates for various liquid crystal displays.

However, when the screen size of a display is further increased, or when the cost of a display is further decreased, it is necessary to use an insulating substrate which is low in price and which is usually a form of glass. There are, therefore, demands for an economic technique which enables the formation of a thin film transistor, for operating a liquid crystal display in an active matrix system, on a low priced glass substrate with stable properties.

Amorphous silicon or polycrystalline silicon is generally used as an active layer for a thin film transistor, polycrystalline silicon which shows a high operating speed being useful when a thin film transistor and a driving circuit are to be formed integrally.

However, in order to allow the use of the usual glass substrate for a thin film semi-conductor device, a technique of forming a silicon thin film at a low temperature of 600°C or less is required. The same applies to the use of integrated circuits including SRAMS or the like and the use of multi-layer LSIs. Hitherto, it has been possible to form only poor quality silicon thin films, which have low crystallinity and which have mainly [220] preferred orientation, using a conventional low pressure chemical vapour deposition at a temperature of 600°C or less. As a result, polycrystalline silicon film is generally considered unsuitable for semi-conductor devices, and various methods have been tried for improving the quality of silicon thin films so that an adequate active layer for a thin film semi-conductor device can be formed.

One such method comprises forming an active layer of a thin film semi-conductor device by depositing a silicon thin film at a deposition temperature which is raised near the highest possible process temperature (610°C to 640°C) and at a deposition pressure of 40 mTorr to 750 mTorr (Appl.Phys. Lett., 50 (26), P.1894 (1987)). Another such method comprises depositing a silicon thin film on an insulating substrate by low pressure chemical vapour deposition at a temperature of 570°C or less and then heating the film at a temperature of 640°C or less for twenty four hours to change the orientation and crystallinity of the deposited film (Japanese Laid Open Patent No. 63-307776). A further such method comprises forming an active layer for a thin film semi-conductor device by depositing an amorphous silicon thin film at a temperature of about 300°C or less, by RF magnetron sputtering or plasma chemical vapour deposition, and then applying various laser beams to the film (Japanese Journal of Applied Physics, 28, P. 1871 (1989) and Technical Research Report of the Society of Electron Information Communication EID-88-58).

Nevertheless, the above described prior art methods have various problems.

The method of depositing a silicon thin film serving as an active layer using conventional low pressure chemical vapour deposition at a raised temperature has the problem that the deposition temperature is too high in that a low priced glass substrate can only be employed if the highest temperature in the production process is about 600°C and the time that the highest temperature is sustained is limited to several hours or less. Also, when a thin film semi-conductor device is applied to a three dimensional LSI, SRAM or the like, the thin film semi-conductor device is preferably produced at a highest process temperature of 600°C or less for the protection of any lower layer transistors and connections. In addition, since the conventional low pressure chemical vapour deposition can form only silicon thin films having low crystallinity and having mainly [220] preferred orientation, the process is not suitable for forming polycrystalline silicon thin films for active layers of semi-conductor devices and thus such films cannot be used as switching elements for liquid crystal displays nor can they be applied to three dimensional LSIs, SRAMS and the like.

On the other hand, improvement of the properties of a thin film semi-conductor device by heating the deposited silicon thin film or applying laser beams thereto renders the production process complicated and tedious as compared with conventional low pressure chemical vapour deposition. This also results in such problems as a decrease in productivity, the need for expensive processing apparatus and an increase in production cost.

Accordingly, the present invention seeks to solve the above described problems, and to improve the characteristics of a silicon thin film for use in a thin film semi-conductor device produced by low pressure chemical vapour deposition.

According to the present invention, there is provided a method of producing a thin film semi-conductor device comprising forming an insulating layer on a surface of a substrate, and depositing a silicon thin film as an active layer above the insulating layer by low pressure chemical vapour deposition, characterised in that the low pressure chemical vapour deposition is effected using monosilane ($SiH_4$) as a source gas and at a total reactor pressure of 15 mTorr or less or a silane partial pressure of 10 mTorr or less.

In the present invention, even when the silicon thin film is deposited by low pressure chemical vapour deposition at a low temperature of 600°C or less, the film properties such as crystallinity, preferred orientation, optical properties and so on may be improved so that a thin film semi-conductor device having desirable characteristics may be produced reliably and economically.

According to another aspect of the present invention, there is provided a thin film semi-conductor device produced by the above method.

In accordance with a further aspect of the present invention, there is provided a thin film semi-conductor device comprising a substrate having at least the surface covered with an insulating material and a silicon film semi-conductor layer formed on one of the sides of said substrate so as to serve as an active layer of a transistor characterised in that said semiconductor layer comprises a silicon film having a refractive index of 4.06 or less for light of a wave length of 589.3 nm in air, a silicon film having a refractive index of 4.46 or more for light of a wave length of 308 nm in air or a silicon film having an extinction index of 0.81 or less at a wave length of 404.7 nm.

In accordance with still a further aspect of the present invention, there is provided a thin film semiconductor device comprising a substrate having at least a surface covered with an insulating material and a silicon film semi-conductor layer formed on one of the sides of said substrate so as to serve as an active layer of a transistor, characterised in that said semiconductor layer comprises a silicon film having a degree of crystallinity which reaches 40% or more when being measured by Raman spectroscopy.

The present invention is described further, by way of example, with reference to the accompanying drawings, in which:-

Figures 1 (a) to 1 (f) are sectional views showing steps in the production of a silicon thin film semiconductor device in accordance with the present invention;

Figure 2 is a graph showing the characteristics of a thin film transistor in accordance with the present invention as compared with those of a prior art thin film transistor;

Figure 3 is a graph showing the relation between the pressure in a reactor during production of a thin film transistor according to the present invention and the effective mobility of the thin film transistor;

Figure 4 is a graph showing the relation between the pressure in the reactor and the orientation of a deposited silicon thin film; and

Figure 5 is a graph showing the relation between the pressure in the reactor and the crystallinity of a deposited silicon thin film as measured by two different methods, namely Raman spectroscopy and multi-wave length spectroscopic ellipsometry.

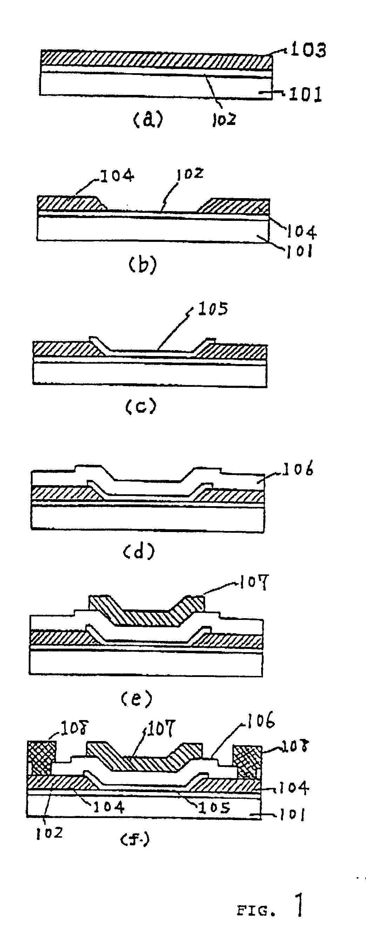

Figures 1 (a) to 1 (f) are sectional views showing steps in a process according to the present invention for producing a polycrystalline silicon thin film transistor in the form of an MIS-type field effect transistor.

In this instance, a 235 mm square of quartz glass is employed as a substrate 101, such glass being able to withstand process temperatures up to 600°C. However, materials which can withstand temperatures of 600°C or more can also be used for the substrate regardless of type and size. For example, the substrate may comprise a three dimensional LSI formed on a silicon wafer. The substrate may also comprise a ceramic substrate such as a sintered alumina substrate ($Al_2O_3$), an aluminium nitride substrate (AIN), a silicon carbide substrate (SiC), or a graphite substrate or the like. Alternatively, a plate of a high melting point metal such as tungsten, molybdenum or the like can be used as a substrate.

The quartz glass substrate is first immersed in 60% nitric acid, which is boiled for five minutes, and is then rinsed in pure water through which nitrogen gas is bubbled. When a substance, such as a metal or the like, which erodes or deteriorates in acid is used as a substrate, it is unnecessary to wash the substrate with nitric acid. Other effective methods of washing a substrate include washing with an organic solvent, such as acetone or methyl ethyl ketone (MEK) or the like, followed by rinsing with ethanol and then pure water; and washing with an aqueous solution containing an organic surfactant or a silicon containing surfactant and then rinsing with pure water.

A silicon dioxide ($SiO_2$) film 102 having a thickness of 2000 Å is then deposited as a protective under layer on the washed quartz substrate by an atmospheric pressure chemical vapour phase deposition process (APCVD process). The $SiO_2$ film 102 is required for stabilising the properties of a later deposited silicon thin film and also the performance of a thin film transistor comprising the silicon thin film. The protective film 102 has the function of preventing movable ions such as sodium ions and the like contained in the glass substrate 101, or in a sintering assistance material added to a ceramic plate if such is used as the substrate 101, from diffusing and mixing in the transistor portion. When a metal plate is used as the substrate 101, the $SiO_2$ film 102 is necessary for ensuring insulating propeties. Further, in a three dimensional LSI element, the protective

4

film 102 corresponds to an inter-layer insulating film between transistors or connections. The substrate temperature during deposition of the SiO₂ film 102 is 300°C. The SiO₂film 102 is deposited by the APCVD process using 20% silane diluted with nitrogen at 600 sccm together with oxygen at 840 sccm. During this process, the deposition rate of the SiO₂ film 102 is 3.9 Å/sec.

A silicon thin film 103 containing an impurity serving as a donor or acceptor is then deposited by a low pressure chemical vapour deposition process (low pressure CVD process) (see Figure 1 (a)). In this instance, phosphorus is selected as the impurity for the purpose of forming an n-type transistor, but any one of the elements in Group V and VI other than phosphorus can be added as impurity in the case of an n-type transistor and any one of the elements in Group II and III such as boron or the like can be added as impurity in the case of a p-type transistor. The silicon thin film 103 containing the impurity forms the source and drain regions of the transistor.

Methods of adding the impurity include the CVD process itself, a method of forming an intrinsic silicon film containing no impurity and then adding impurity by diffusion from a vapour phase or a solid phase in contact with the silicon film, and a method of implanting impurity ions into the intrinsic silicon film formed. The advantage of the later two methods, comprising forming an intrinsic silicon film and then diffusing an impurity therein or implanting impurity ions into the silicon film, is that these enable the impurity to be added only to a desired portion of the intrinsic silicon film. For example, both such methods enable a transistor to be produced having a gate electrode terminal and a source terminal or a drain terminal in self alignment. They also enable the formation of a silicon film having different portions containing different concentrations of the impurity and thus having different current densitites and specific resistances, thereby making it possible to cause a current to flow only through desired portions in the silicon film.

In this instance, in which phosphorus is selected as the impurity, the silicon thin film 103 containing the impurity is deposited to a thickness of 1500 Å using a gas containing phosphine (PH₃) and silane. During deposition, monosilane at 200 sccm, a helium-phosphine gas mixture, containing 99.5% helium and 0.5% phosphine, at 6 sccm, and helium at 100 sccm are passed through a low pressure CVD reactor having a volume of 184.5 l, the deposition temperature is 600°C, and the pressure in the reactor is 100 mTorr. At this time, the deposition rate is 29.6 Å/min, and the sheet resistance immediately after the formation of the film is 2025 Ω/square.

A resist is then formed on the silicon thin film 103, and the thin film is patterned using a plasma mixture containing carbon tetrafluoride (CF₄) and oxygen (O₂) to form source/drain regions 104 (see Figure 1 (b)). Impurities such as residual resist and the like are removed by washing by immersion in boiling nitric acid for five minutes, and the natural oxide film on the source/drain regions 104 is then removed by immersion in 1.67% hydrofluoric acid for twenty seconds.

Immediately after washing, a silicon thin film for providing a channel portion 105 is formed by a low pressure CVD process (see Figure 1 (c)). The volume of the low pressure CVD reactor used for this deposition is 184.5 l, and a plurality of the substrates are placed in series horizontally near the reactor centre. Source gas and dilution gas, such as helium, nitrogen, argon, hydrogen or the like, are introduced into the reactor as occasion demands through the lower portion thereof and are exhausted through the upper portion thereof. A heater divided into three zones is disposed outside the reactor so that a isothermal zone at a desired temperature can be formed substantially at the centre of the reactor by separate adjustment of the three zones. The length of the isothermal zone is about 350 mm and it shows a temperature deviation of, for example, 0.2°C or less when the set temperature is 600°C. If the intervals between the respective substrates inserted into the reactor is 10 mm, therefore, thirty five substrates can be treated during one batch. In this instance, seventeen substrates are placed in the isothermal zone at intervals of 20 mm.

Evacuation of the reactor is performed by a rotary pump and a mechanical booster pump connected in series. In a state wherein both pumps are operated at a reactor temperature of 600°C, the equilibrium pressure in the reactor is 5.05 mTorr when helium is caused to flow at 9 sccm, and is 25.2 mTorr when helium is caused to flow at 74 sccm. Although the equilibrium pressure in the reactor essentially changes linearly within the flow rate range between the above values, deviation from linearity occurs for a wide flow rate range. For example, in a state where the pumps are operated at 600°C, the equilibrium pressure is 56.56 mTorr when helium is caused to flow at 200 sccm, and the pressure is 186.04 mTorr when helium is caused to flow at 1 SLM. Although the equilibrium pressure changes linearly between the flow rate of 200 sccm and that of 1 LSM, the pressure dependence on the flow rate is different from that of the flow rate range between 9 sccm and 74 sccm. The pressure is measured by a capacitance manometer, which is not dependent on gas type.

The substrate 101 having the source/drain regions 104 formed thereon but having no natural oxide surface film is immediately inserted into the low pressure CVD reactor so that the surface of the substrate faces downwards. During insertion, the temperature in the reactor is between 395°C and 400°C, and a nitrogen atmosphere is maintained inside the reactor. A nitrogen curtain is formed in a region near the inlet of the reactor using nitrogen at about 6 SLM so as to minimise the flow of air in the reactor when the substrate is inserted into the reactor.

After the substrate has been inserted into the reactor, evacuation and a leak test are carried out. If no abnormality is detected, the temperature in the reactor is increased from the insertion temperature of 400°C to the deposition temperature. In this embodiment, the silicon thin film serving as the channel portion 105 is deposited at 600°C, and the time required for increasing the temperature is one hour. The time needed for increasing the temperature must be changed according to the deposition temperature. For example, about one hour and thirty minutes is required when the deposition temperature is 630°C, and as little as thirty five minutes can suffice when the deposition temperature is 550°C. During the period of temperature rise, the two pumps are operated, and inert gas or reducing gas having a purity of at least 99.99% is caused to flow continuously. Examples of a gas that can be used as the inert gas or reducing gas include a pure gas such as hydrogen, helium, nitrogen, neon, argon, xenon, krypton and the like and gas mixtures thereof. When helium with a purity of 99.9999% is caused to flow continuously at 350 sccm, the pressure within the reactor is kept at 80.8 ± 1.3 mTorr with a 95% level of confidence. In this instance, the pressure in the reactor is 80.95 mTorr during the temperature rise.

After the temperature has reached the deposition temperature, the silicon thin film for providing the channel portion 105 is deposited using a pre-determined amount of silane or a gas mixture containing silane and a dilution gas as a source gas. It is possible for the dilution gas to be the same gas as that employed during the temperature rise. In any case, the purity of each gas is preferably 99.999% or more. In this instance, the silicon thin film is deposited using a flow of silane with a purity of 99.999% or more at 10 sccm, but without using the dilution gas. During the deposition, the total pressure in the reactor is 8.54 mTorr. Since the pressure in the reactor is the sum of the partial pressure of the silane used as a source gas and the partial pressure of hydrogen which is a reaction product, the partial pressure cannot be precisely determined. The partial pressure is therefore roughly estimated from the equilibrium pressure in the reactor when inert helium gas is caused to flow at 10 sccm under identical conditions. The partial pressure of silane estimated by this method is 5.4 mTorr. The silicon thin film which forms the channel portion 105 is deposited to a thickness of 250 Å at a deposition rate of 14.27 Å/min.

The thus deposited silicon thin film is then patterned with a resist and etched using a plasma mixture containing carbon tetrafluoride and oxygen to form the channel portion 105 (see Figure 1 (c)). In this instance, the deposited silicon thin film is etched using a vacuum plasma of 15 Pa containing $CF_4$ and $O_2$ in a ratio of 50 sccm : 100 sccm with the power being 700 W at an etching rate of 7.6 Å/sec.

After washing with 96% sulphuric acid at 97°C for twenty minutes and immersion in 60% boiling nitric acid for thirty minutes, a gate insulating film 106 is then deposited by the APCVD process (see Figure 1 (d)). In this instance, the gate insulating film 106 is an $SiO_2$ film, which is deposited to a thickness of 1500 Å using a nitrogen/silane gas mixture containing 20% of silane at 300 sccm and oxygen at 420 sccm at a substrate temperature of 300°C. The deposition rate is 1.85 Å/sec. The refractive index of the film is 1.455 for light of a wave length of 6328 Å and the etching rate in an aqueous solution of 1.67% hydrofluoric acid at 25°C is 21.3 Å/sec.

A thin film serving as a gate electrode 107 is then deposited by sputtering, evaporation or a CVD process or the like. Although, in this instance, indium tin oxide (ITO) is selected as a material for the gate electrode and is deposited to a thickness of 2000 Å by a sputtering process, a metal material such as aluminium, chromium or the like, a silicon film, or a silicon metal compound or the like can be used as a material for the gate electrode. After the thin film serving as the gate electrode 107 has been deposited, the gate electrode is formed (see Figure 1 (e)) and contact holes are then opened in the gate insulating film 106. Source and drain take off electrode terminals 108 are then formed by a sputtering process to complete the transistor (see Figure 1 (f)).

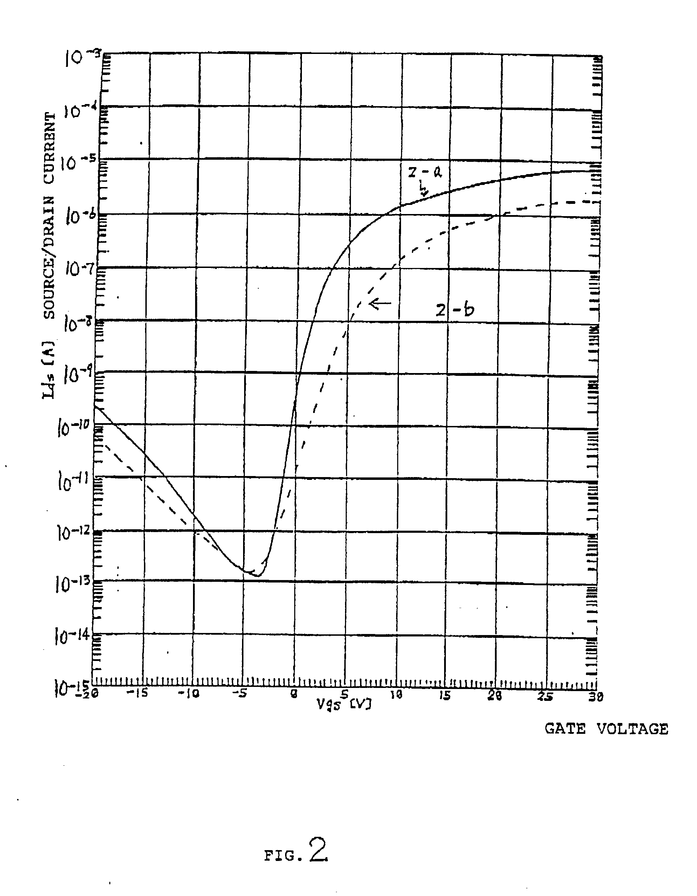

Figure 2 shows the $V_{GS}$-$I_{DS}$ characteristic (2-a) of a sample thin film transistor (TFT) formed by the above described method. In the Figure, $I_{DS}$ is the source/ drain current, and $V_{GS}$ is the gate voltage, and measurements were taken at a source/drain voltage $V_{DS}$ = 4 V and a temperature of 25°C. The transistor channel portion had a length $l$ of 10 μm and a width W of 10 μm. The on current $I_{DS}$ flowing when the transistor was turned on was 1.32 μA for $V_{DS}$ = 4 V and $V_{GS}$ = 10 V. The off current $I_{DS}$ or minimum $I_{DS}$ was 0.12 pA at $V_{DS}$ = 4 V and $V_{GS}$ = -3.5 V. The thin film transistor had good characteristics with an on/off ratio greater than seven orders of magnitude. The effective electron mobility obtained from the saturation current region of the transistor was 3.9 $cm^2$/v.s.

A conventional thin film transistor, formed according to the prior art by the same process as that employed above except for the step of depositing the silicon thin film providing the channel portion 105, will now be described. In this prior art example, when the silicon thin film for the channel portion 105 is deposited, the time taken for increasing the temperature is one and a half hours, and helium having a purity of 99.9999% is continuously passed at 350 sccm during the temperature rise. The silicon thin film is deposited to a thickness of 250 Å° at a deposition temperature of 630°C with a silane flow rate of 150 sccm without using a dilution gas. During the deposition, the pressure in the reactor is 49.2 mTorr, and the partial pressure of silane estimated by using helium in place of silane is 39.7 mTorr. The deposition rate of the silicon thin film is 73.4 Å/min. Figure 2 shows the $V_{GS}$ -$I_{DS}$ characteristic (2-b) of such a conventional thin film transistor which has the same size and is measured under the same conditions as the thin film transistor produced according to the invention. In the case, the on current $I_{DS}$ was 0.12 µA, the off current $I_{DS}$ was 0.15 pA, and the on/off ratio was less than six orders of magnitude. The effective electron mobility determined from the saturation current region of the transistor was 2.4 cm²/v.s.

When a silicon film is deposited by low pressure CVD to form the channel portion of a transistor, in the prior art the film has generally been deposited at a high temperature of 630°C or more, since the higher the deposition temperature, the better the characteristics of the transistor. However, a comparison of the results obtained in the case of a thin film transistor according to the present invention, with the results obtained in the case of the thin film transistor which corresponds to the prior art, show that the thin film transistor having a principal portion comprising the silicon thin film deposited by low pressure CVD at a total reactor pressure of 8.54 mTorr and a silane partial pressure of 5.4 mTorr has high performance, even if the deposition temperature is as low as 600°C, by comparison with the prior art thin film transistor wherein the corresponding deposition temperature is 630°C.

## EXAMPLES 1

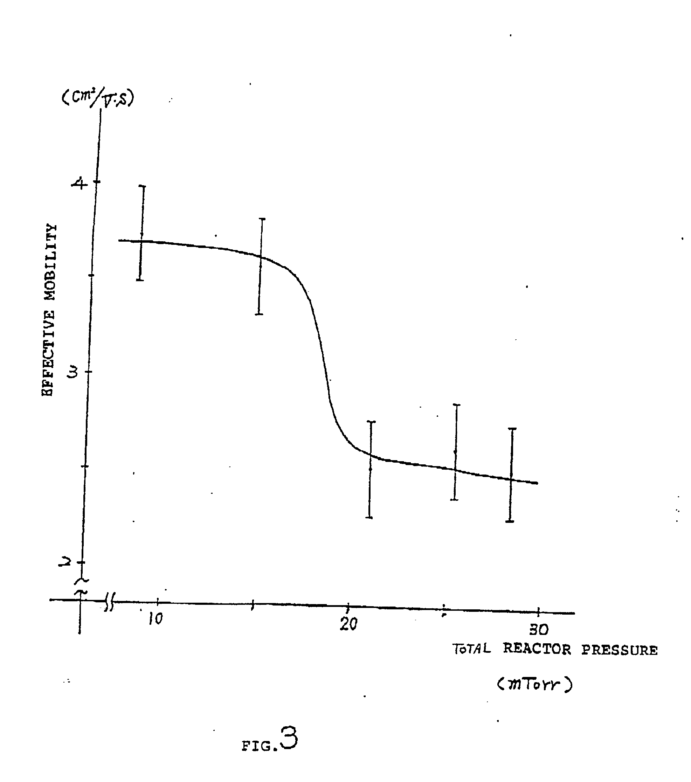

Various further thin film transistors were formed by the process described above according to the invention. In these further examples, when the silicon thin film was deposited, the time needed for increasing the temperature was one hour, and helium having a purity of 99.9999% was continuously passed at 350 sccm during the temperature rise. The silicon thin films for providing the channel portions 105 were deposited to a thickness of 250 Å at a deposition temperature of 600°C with a silane flow rate varying in the range from 10 sccm to 70 sccm at discrete 15 sccm intervals. Figure 3 shows the effective electron mobility (determined from the saturation current region) of each of the thin film transistors as a function of the pressure in the reactor. Table 1 below shows the silane partial pressure, estimated by using helium in place of silane, the deposition rate and the effective electron mobility for each sample. The errors shown in Figure 3 and Table 1 are estimations obtained with a 95% level of confidence.

## Table 1

| Sample No. Silane Flow rate (SCCM) | Pressure in Reactor (mTorr) | Silane Partial Pressure (mTorr) | Deposition Rate (Å/min) | Effective Mobility (cm$^2$/v.s) |
|---|---|---|---|---|
| 3-1 70sccm | 28.4 ±0.8 | 24.0 ±1.3 | 35.6 ±0.3 | 2.52 ±0.25 |
| 3-2 55sccm | 25.4 ±0.8 | 19.3 ±1.3 | 32.4 ±0.3 | 2.62 ±0.25 |
| 3-3 4osccm | 21.1 ±0.8 | 14.7 ±1.3 | 28.5 ±0.3 | 2.52 ±0.25 |
| 3-4 25sccm | 15.0 ±0.8 | 10.0 ±1.3 | 22.4 ±0.3 | 3.57 ±0.25 |
| 3-5 10sccm | 8.5 ±0.8 | 5.4 ±1.3 | 14.3 ±0.3 | 3.73 ±0.25 |

As can be seen from Table 1 or Figure 3, when the pressure in the reactor is 15 mTorr or less, i.e. the silane partial pressure is 10 mTorr or less, as in Sample No. 3-4 or 3-5, the effective mobility is improved by 40% or more, and a transistor having good characteristics can be obtained.

## EXAMPLE 2

Another thin film transistor was formed by the process according to the invention. In this case, when the channel portion silicon thin film was deposited, the time needed for increasing the temperature was one hour, and helium having a purity of more than 99.9999% was continuously passed at 350 sccm during the temperature rise. The silicon thin film was deposited to a thickness of 250 Å using silane at 40 sccm diluted with helium at 710 sccm at a deposition temperature of 600°C. During the deposition, the total pressure in the reactor was 146.4 mTorr. The silane partial pressure calculated by using Dalton's law of partial pressure was 7.81 mTorr.

The deposition rate was 24.7 Å/min. The effective electron mobility determined from the saturation current region of the thin film transistor was 3.77 cm$^2$/v.s.

A comparison of sample 3-3 above with the present example shows that, when the silane partial pressure is 10 mTorr or less due to the use of a dilution gas, the effective mobility is improved by about 50% even if the pressure in the reactor is 15 mTorr or more, and a transistor having good characteristics can be obtained.

## EXAMPLES 3

In some further examples, SiO$_2$ under layer films 102 were formed on both quartz glass substrates and single crystal silicon wafer substrates. Silicon thin film for providing the channel portions 105 was subsequently formed on each of the under layer films. The properties of the silicon thin film were then examined.

The quartz glass used as a substrate had a diameter of 75 mm and a thickness of 1.2 mm. The single crystal silicon wafer had a [100] orientation, and was doped with phosphorus to provide an n-type semi-conductor. The resistivity of the wafer was 3.0 Ω cm. Each of the substrates was immersed in 60% boiling nitric acid for five minutes for the purpose of removing contaminant from the surface of each substrate, and then immersed in an aqueous solution of 5% hydrofluoric acid for ten seconds for the purpose of removing the natural oxide film formed on the surface of each substrate. Immediately after washing, the SiO$_2$ under layer film 102 was deposited to a thickness of 2000 Å by the APCVD process. The deposition conditions were precisely the same as those for depositing the SiO$_2$ under layer film 102 in the process described above.

Each of the substrates was then heated in an atmosphere of nitrogen at 600°C for two hours.

Properties such as refractive index, etching rate and so on and the thickness of the SiO$_2$ film formed by the CVD process are generally changed by subsequent heat treatment; and changes in the properties of the SiO$_2$ under layer film 102 affect the properties of the silicon thin film for providing the channel portion 105 deposited thereon.

In the present examples, the heat treatment was performed for re-creating the thermal history to which the SiO$_2$ under layer film 102 was subjected when the silicon thin film 103 containing impurity was formed. In this manner, the silicon thin films for providing the channel portion 105 were deposited under the same conditions as those for forming the channel portion silicon thin film in the above described process.

Each of the substrates was then immersed in boiling nitric acid for five minutes and then in an aqueous solution of 1.67% hydrofluoric acid for twenty seconds so as to clean the surface of the SiO$_2$ film 102. During the immersion, approximately 400 Å of the SiO$_2$ film was removed. Each of the substrates was then rinsed for fifteen minutes in pure water with nitrogen bubbled through it and was dried by a spin dryer, after which the silicon thin film for providing the channel portions 105 was deposited on the SiO$_2$ film 102 by low pressure CVD. The deposition was performed by the same low pressure CVD apparatus as that used for depositing the channel portion silicon thin film in the described process.

In the case of the silicon wafer substrates, silicon thin films were deposited under conditions the same as those used in Examples 1 and 2. Namely, after the substrates had been inserted into the reactor kept at a temperature of 395°C to 400°C, the temperature in the reactor was increased to the deposition temperature of 600°C over an interval of one hour. During the time that the reactor temperature was increased to the deposition temperature of 600°C, the mechanical booster pump and the rotary pump were operated, and helium having a purity of 99.9999% or more was passed at 350 sccm. Silicon films were deposited respectively under the same conditions as those employed in Examples 1, i.e. the silane flow rate was stepped by intervals of 15 sccm in the range of 10 sccm to 70 sccm without using a dilution gas, and under the same conditions as those employed in Example 2 i.e. silane at 40 sccm was diluted with helium at 710 sccm. The thickness of each of the deposited films was 250 Å.

In the samples in which a quartz glass plate was used as the substrate, the silicon thin films were deposited under the same conditions except insofar as increasing the reactor temperature was concerned and in that the thickness of the deposited film was varied. In this case instead, the reactor temperature was increased to 600°C from 400°C while passing nitrogen having a purity of more than 99.99% at 900 sccm whilst keeping the pressure in the reactor at about 160 mTorr; and the films were deposited to thicknesses of 5000 Å ± 250 Å, 1000 Å ± 50 Å and 1370 Å ± 30 Å.

The crystallographic orientation in the direction perpendicular to the substrate surface in each of the silicon thin films which were thus deposited to a thickness of 5000 Å ± 250 Å were examined by x-ray diffraction. Namely, the volume ratio of orientation in each of the directions was determined from the measured x-ray diffraction intensities and compared to the diffraction intensity ratio of a silicon powder which was completely randomly oriented. The plane anisotropy was compared.

The crystallinity of a sample of the silicon thin film having a thickness of 1000 Å ± 50 Å was evaluated by laser Raman spectroscopy, and the crystallinity of samples of the silicon thin films having thicknesses of 1370 Å ± 30 Å and 250 Å, respectively, was evaluated by multi-wave length polarisation analysis (i.e. by multi-wave length spectroscopicellipsometry employing MOSS-ES4G apparatus produced by Sopra Co. Ltd., France).

In the laser Raman spectroscopy, scanning was performed within the range of wave numbers from 830 $(cm^{-1})$ to 108 $(cm^{-1})$ so that crystallinity was determined from the relative ratio between the Raman scattering integrated intensity Ic at about 520 $(cm^{-1})$, which is an optical mode frequency corresponding to crystal silicon, and the sum Ia of scattering integrated intensities, including an acoustic transverse wave mode (TA) at about 130 $(cm^{-1})$, an acoustic longitudinal wave mode (LA) at about 290 $(cm^{-1})$, an optical longitudinal wave mode at about 405 $(cm^{-1})$ and an optical transverse wave mode (TO) at about 480 $(cm^{-1})$, which are frequencies corresponding to amorphous silicon (Appl. Phys. Lett., 40(6), 534 (1982)). Namely, the crystallinity was calculated from the following equation:

$$\rho = \frac{\sigma}{\sigma + K ( 1 - \sigma )}$$

where $\sigma = Ic/(Ic + Ia)$ and K is a correction factor for scattering integrated intensity, a value of 0.88 being used for K in this case.

In the multi-wave length elipsometry, scanning was performed using a rotary polariser within the range of wave lengths from 250 nm to 850 nm. The incident angle was 70°. The values of tan $\psi$ and cos $\Delta$ for the silicon thin film were obtained. The spectra of amorphous silicon and the spectra of crystal silicon, as measured, are combined with each other at a desired volume ratio between amorphous and crystal silicon in accordance with the BRUGGEMAN's formula (D. A. G. BRUGGEMAN, Ann. Phys., (Leipzig) 24, 636 (1935)) which concerns combi-nation of complex indices of refraction. The crystallinity was then determined according to a mixture ratio by volume at which the resultant spectra were best in agreement with the measured spectra.

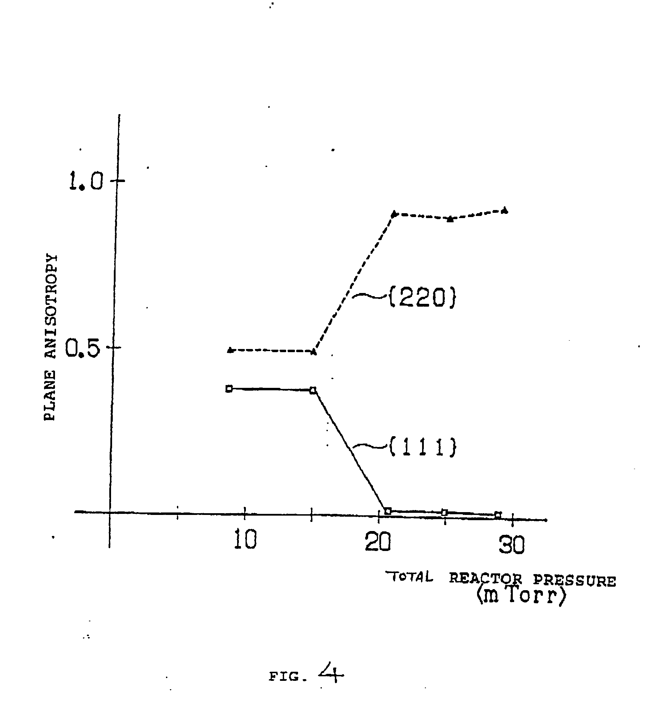

Figure 4 shows the relation between the pressure in the reactor and the plane anisotropy of the silicon thin film obtained by the low pressure CVD process. In the reactor, only the flow rate of silane was changed from 10 sccm to 70 sccm, and the resulting pressure is shown on the abscissa. The silicon thin films were deposited at a pressure which is much lower than the 40 mTorr to 750 mTorr used in a conventional low pressure CVD process. It can be seen from Figure 4 that reflection from the [220] plane is essentially completely produced at a total pressure of about 20 mTorr, which reflection from the [111] plane becomes strong at a total pressure of 15 mTorr or less. The total pressure in the reactor in relation to the partial pressure of silane obtained by using helium in place of silane is shown in Table 1 above, and the silane partial pressure corresponding to a total pressure of 15 mTorr at which the plane anisotropy is changed is 10 mTorr.

These results were compared with those for silicon thin film deposited as described above using silane at 40 sccm, which was diluted with helium at 710 sccm, when the total pressure in the reactor was 146.4 mTorr and the silane partial pressure calculated using Dalton's law of partial pressure was 7.81 mTorr. In regard to the plane anisotropy, orientation in the [111] plane of this film was 0.279, and orientation in the [220] plane was 0.646. It was thus found that the orientation in the [111] plane can be increased by decreasing the silane partial pressure to 10 mTorr or less by dilution, by comparison with the orientation of 0.021 obtained in the [111] plane as shown in Figure 4 when the silane flow rate was 40 sccm without any dilution and the total reactor pressure was 21.1 mTorr.

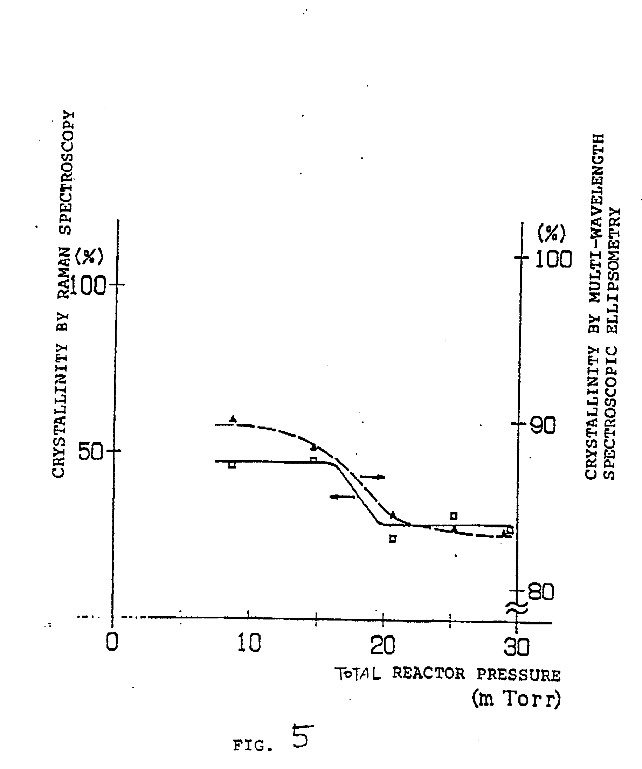

Figure 5 shows the degree of crystallinity of a sample having a thickness of 1370 Å, measured by multi-wave length ellipsometry, and of a sample having a thickness of 1000 Å, measured by laser Raman spectroscopy. Since different measurement principles, definitions of crystallinity and thicknesses are employed in the two methods, the absolute values are not in agreement with each other. However, Figure 5 shows stepwise changes in the degree of crystallinity in both cases at a total reactor pressure of 15 mTorr or a silane partial pressure of 10 mTorr. When the silicon thin film was obtained by deposition using silane at 40 sccm which was diluted with helium at 710 sccm and the silane partial pressure was 7.81 mTorr, the crystallinity measured by Raman spectroscopy was 41% and the crystallinity measured by multi-wave length spectroscopic ellipsometry was 91%.

It is therefore effective to decrease the total reactor pressure to 15 mTorr or less, or to decrease the silane partial pressure to 10 mTorr or less, for obtaining a silicon thin film having a mainly [111] preferred orientation or a high crystallinity by low pressure CVD at a low temperature of 600°C or less.

The refractive index and extinction index of the silicon thin films formed on an $SiO_2$ under layer film 102 on a silicon wafer substrate were also measured by multi-wave length spectroscopic ellipsometry (using MOSS-ES4G apparatus produced by Sopra Co. Ltd., France). The silicon thin films were deposited under the same conditions as those for depositing the channel portion silicon thin films to form transistors in Examples 1 and 2, and the thickness of the films was 250 Å within the range of error. An estimation of the variation in thicknesses taking measurement error into account was 5.2 Å with a 95% level of confidence. The properties of the same silicon thin films having the thickness of 250 Å which were examined with respect to the transistor characteristics thereof in Examples 1 and 2 were thus also examined with respect to the optical characteristics thereof in the present Example. Table 2 below shows the refractive index for light of 589.3 nm in air, the refractive index for light of 308 nm in air and the extinction index for light of 404.7 nm for the silicon thin films having a thickness of 250 Å, all of which were measured by multi-wave length spectroscopic ellipsometry. Also shown is the crystallinity of the silicon thin film having a thickness of 1000 Å, which was measured by Raman spectroscopy, and the effective mobilities shown in Examples 1 and 2, together with the total reactor pressure and the silane partial pressure for each of the samples.

## Table 2

| Source gas Flow Rate | Pressure in Reactor $P_{TOTAL}$ (mtorr) | Silane Partial Pressure $P_{SiH_4}$ (mtorr) | Effective Mobility $\mu$ (cm²/ v.sec) | Crystal- linity by Raman Spectro- scopy (%) | Refractive Index in Air 589.3nm N | 308nm N | Extinction index for Light of 404.7nm K |
|---|---|---|---|---|---|---|---|
| $SiH_4$ 70sccm | 28.4 ±0.8 | 24.0 ±1.3 | 2.52 ±0.25 | 27.8 | 4.202 | 4.300 | 1.066 |
| $SiH_4$ 55sccm | 25.4 ±0.8 | 19.3 ±1.3 | 2.62 ±0.25 | 33.6 | 4.192 | 4.310 | 1.047 |
| $SiH_4$ 40sccm | 21.1 ±0.8 | 14.7 ±1.3 | 2.52 ±0.25 | 24.6 | 4.173 | 4.336 | 1.010 |
| $SiH_4$ 25sccm | 15.0 ±0.8 | 10.0 ±1.3 | 3.57 ±0.25 | 46.7 | 4.059 | 4.463 | 0.808 |
| $SiH_4$ 10sccm | 8.5 ±0.8 | 5.4 ±1.3 | 3.73 ±0.25 | 44.6 | 4.013 | 4.503 | 0.734 |
| $SiH_4$ 40sccm He 710sccm | 146.4 ±3.8 | 7.81 ±0.20 | 3.77 ±0.25 | 41.0 | 4.059 | 4.557 | 0.744 |

It can be seen from Table 2 that, when a silicon thin film having crystallinity of over 40% as measured by Raman spectroscopy is used in the channel portion of a transistor, the effective mobility is significantly improved. It can also be seen that, when a silicon thin film having a refractive index of 4.06 or less for light of 589.3 nm in air, a refractive index of 4.46 or more for light of 308 nm in air or an extinction index of 0.81 or less for light of 404.7 nm is used in the channel portion semi-conductor layer, the effective mobility can be significantly improved.

As described above, the present invention enables the production of a thin film semi-conductor device comprising a substrate having a surface covered with an insulating material and a silicon thin film formed on the substrate so as to serve as an active layer, wherein the effective mobility is improved by depositing the silicon thin film by a low pressure CVD process, wherein the total pressure in the reactor is 15 mTorr or less, or the silane partial pressure is 10 mTorr or less, in order to adjust the crystallinity and optical characteristics of the silicon thin film and give the silicon thin film a [111] preferred orientation. The present invention enables the production of a thin film semi-conductor device having good transistor characteristics, and has the advantages of increasing the performance of an active matrix liquid crystal display in which such a thin film transistor is used and decreasing the cost thereof, whilst also simplifying making LSI multi-layer integrated structures.

## Claims

1. A method of producing a thin film semi-conductor device comprising forming an insulating layer (102) on a surface of a substrate (101), and depositing a silicon thin film as an active layer (105) above the insulating layer by low pressure chemical vapour deposition, characterised in that the low pressure chemical vapour deposition is effected using monosilane ($SiH_4$) as a source gas and at a total reactor pressure of 15 mTorr or less or a silane partial pressure of 10 mTorr or less.

2. A method according to claim 1 characterised in that the low pressure chemical vapour deposition is carried out at a temperature of 600°C or less.

3. A method according to claim 1 or 2 characterised in that the low pressure chemical vapour deposition is effected using monosilane alone as a source gas and at a total reactor pressure of 15 mTorr or less and a silane partial pressure of 10 mTorr or less.

4. A method according to claim 1 or 2 characterised in that the low pressure chemical vapour deposition is effected using monosilane diluted with a dilution gas as a source gas and at a silane partial pressure of 10 mTorr or less.

5. A method according to any preceding claim characterised in that the deposited silicon thin film has a crystallinity of 40% or more as measured by Raman spectroscopy.

6. A method according to any preceding claim characterised in that the deposited silicon thin film has a refractive index of 4.06 or less for light of a wave length of 589.3 nm in air, a refractive index of 4.46 or more for light of a wave length of 308 nm in air and an extinction index of 0.81 or less for light of a wave length of 404.7 nm in air.

7. A silicon thin film semi-conductor device produced by a method according to any preceding claim.

8. A method of depositing a silicon thin film comprising a silicon thin film having a degree of crystallinity which reaches 40% or more when being measured by Raman spectroscopy or a silicon thin film having mainly [111] preferred orientation by a low pressure chemical vapour phase deposition process (LPCVD process) at a low temperature of 600°C or less, characterised in that said silicon thin film is deposited using monosilane ($SiH_4$) as a source gas at a total reactor pressure of 15 mTorr or less or a silane partial pressure of 10 mTorr or less.

9. A thin film semi-conductor device comprising a substrate (101) having at least the surface covered with an insulating material (102) and a silicon film semi-conductor layer (105) formed on one of the sides of said substrate so as to serve as an active layer of a transistor characterised in that said semi-conductor layer comprises a silicon film having a refractive index of 4.06 or less for light of a wave length of 589.3 nm in air, a silicon film having a refractive index of 4.46 or more for light of a wave length of 308 nm in air or a silicon film having an extinction index of 0.81 or less at a wave length of 404.7 nm.

10. A thin film semi-conductor device comprising a substrate (101) having at least a surface covered with an insulating material (102) and a silicon film semiconductor layer (105) formed on one of the sides of said substrate so as to serve as an active layer of a transistor, characterised in that said semi-conductor layer comprises a silicon film having a degree of crystallinity which reaches 40% or more when being measured by Raman spectroscopy.

FIG. 1

FIG. 2

FIG.3

FIG. 4

FIG. 5